# EUROPEAN PATENT SPECIFICATION

(11) **EP 0 484 139 B1**
(45) Date of publication and mention of the grant of the patent: **14.08.1996**
(21) Application number: 91310038.4
(22) Date of filing: 30.10.1991
(51) Int. Cl.: H03G 7/00

(54) **Logarithmic amplifying circuit**
Logarithmischer Verstärker
Circuit amplificateur logarithmique

(30) Priority: 30.10.1990 JP 292866/90
(43) Date of publication of application: 06.05.1992
(73) Proprietor: NEC CORPORATION, Tokyo (JP)
(72) Inventor: Kimura, Katsuji, c/o NEC CORPORATION, Minato-ku, Tokyo (JP)
(74) Representative: Garratt, Peter Douglas

(56) References cited:
- EP-A- 0 248 428
- US-A- 4 680 553
- US-A- 5 057 717

## Description

The present invention relates to a logarithmic amplifying circuit and, more particularly, to a logarithmic amplifying circuit suited for a MOS integrated circuit.

A conventional logarithmic amplifying circuit of this type is generally realized in a bipolar integrated circuit. Such a circuit is disclosed in. eg. EP-A-0.248.428. A logarithmic amplifying circuit realized in a MOS integrated circuit is disclosed in eg. Japanese Patent Laid-Open No. 62-292010.

The logarithmic amplifying circuit in these integrated circuits are designed in such a manner that multistage differential amplifiers are connected in cascade, and squaring full-wave rectifiers are respectively connected to an input of the first stage and output terminals of the subsequent stages. With this arrangement, signals at these input and output terminals are subjected to squaring full-wave rectification, and the outputs from the squaring full-wave rectifiers are added together. For this reason, these outputs are affected by the characteristics of the respective squaring full-wave rectifiers, which include dynamic range characteristics, and hence excellent logarithmic characteristics cannot be obtained.

It is an object of the present invention to provide a logarithmic amplifying circuit which has a wide dynamic range and can obtain excellent logarithmic characteristics.

In one aspect the invention provides a logarithmic amplifier comprising:
a) a plurality of differential amplifier stages each having first and second input nodes and first and second output nodes, said amplifier stages being connected to each other in cascaded arrangement such that said first and second output nodes of a preceding amplifier stage are connected respectively to said first and second input nodes of a succeeding amplifier stage, an input signal being supplied between said first and second input nodes of a first stage of said cascaded arrangement;
b) a plurality of logarithmic full wave rectifier blocks, each rectifier block having first and second input terminals one rectifier block having its input terminals respectively connected to the first and second input nodes of the first amplifier stage, the other rectifier blocks having their input terminals respectively connected to said first and second output nodes of an associated one of said amplifier stages to receive an output signal appearing between said first and second output nodes of the associated amplifier stage, each rectifier block rectifying its respective input signal to produce an output current at first and second output terminals thereof and having logarithmic full-wave rectification with respect to an input voltage;
c) an adder to add output currents from said rectifier blocks to each other and output a signal corresponding to the sum current;
characterised in that
d) each rectifier block includes a first current source, first and second MOS transistors connected in a differential manner, said first MOS transistor having a gate connected to said first input terminal, a drain connected to said first output terminal, a source directly connected to said first current source and a first ratio of a gate width to a gate length, said second MOS transistor having a gate connected to said second input terminal, a drain connected to said second output terminal, a source directly connected to said first current source and a second ratio of a gate width to a gate length, said first ratio being different from said second ratio, a second current source, third and fourth MOS transistors connected in a differential manner, said third MOS transistor having a gate connected to said second input terminal, a drain connected to said first output terminai, a source directly connected to said second current source and a third ratio of a gate width to a gate length, said fourth MOS transistor (M14) having a gate connected to said first input terminal, a drain connected to said second output terminal, a source directly connected to said second current source and a fourth ratio of a gate width to a gate length, said third ratio being different from said fourth ratio, a third current source, fifth
   and sixth MOS transistors connected in a differential manner, said fifth MOS transistor having a gate connected to said first input terminal, a drain connected to said first output terminal, a source directly connected to said third current source and a fifth ratio of a gate width to a gate length, said sixth MOS transistor having a gate connected to said second input terminal, a drain connected to said second output terminal, a source directly connected to said third current source and a sixth ratio of a gate width to a gate length, said fifth ratio being different from said sixth ratio, a fourth current source, seventh and eighth MOS transistors connected in a differential manner, said seventh MOS transistor having a gate connected to said second input terminal, a drain connected to said first output terminal, a source directly connected to said fourth current source and a seventh ratio of a gate width to a gate length, said eighth MOS transistor having a gate connected to said first input terminal, a drain connected to said second output terminal, a source directly connected to said fourth current source and an eighth ratio of a gate width to a gate length, said seventh ratio being different from said eighth ratio, and an output circuit connected to said first and second output terminals for adding the currents output from said rectifier blocks.

Furthermore, said output circuit of said each rectifier block includes a first current mirror circuit having a current input terminal connected to said first output terminal of each rectifier block and thereby supplied commonly with drain currents of said first, third, fifth and seventh MOS transistors and a current output terminal connected to the drains of the second, fourth, sixth and eighth MOS transistors, and a second current mirror circuit having a current input terminal connected to said second output terminal of said each rectifier block and thereby supplied commonly with drain currents of said second, fourth, sixth and eighth MOS transistors and to the current output terminal of said first current circuit, said second current mirror circuit providing via its output terminal a sub total current representing said output signal of said each rectifier block.

Reference will now be made, by way of example, to the accompanying drawings, in which:-
Fig. 1 is a block diagram showing a logarithmic amplifying circuit according to an embodiment of the present invention;
Fig. 2 is a circuit diagram showing a logarithmic full-wave rectifier in the logarithmic amplifying circuit of the present invention;
Fig. 3 is a circuit diagram showing a squaring full-wave rectifier, as a basic unit, constituting the logarithmic full-wave rectifier shown in Fig. 2; and
Figs. 4 and 5 are graphs showing the characteristics of a squaring full-wave rectifier, in which ratio W₁ (gate width)/L₁ (gate length) is used as a parameter.

The present invention will be described below with reference to accompanying drawings.

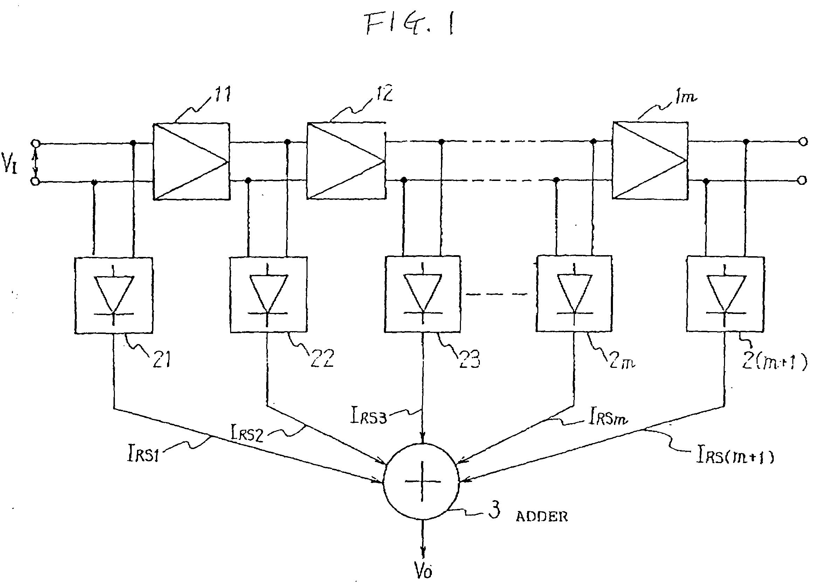

Fig. 1 is a block diagram showing a logarithmic amplifying circuit according to an embodiment of the present invention.

The logarithmic amplifying circuit comprises a plurality of (m) stages of cascaded differential amplifiers 11, 12, ..., and 1m, a plurality of logarithmic full-wave rectifiers 21, 22, ..., and 2(m+1) respectively connected to the input and output terminals of the first-stage differential amplifier 11 and the output terminals of the differential amplifiers 12 to 1m of the subsequent stages and designed to respectively output currents I_{RSJ} (J = 1 to m+1) having logarithmic full-wave characteristics with respect to an input voltage V₁, and an adder 3 for adding the output currents I_{RSJ} from the logarithmic full-wave rectifiers 21, 22, ..., and 2(m+1) and outputting a signal V₀ corresponding to the sum current.

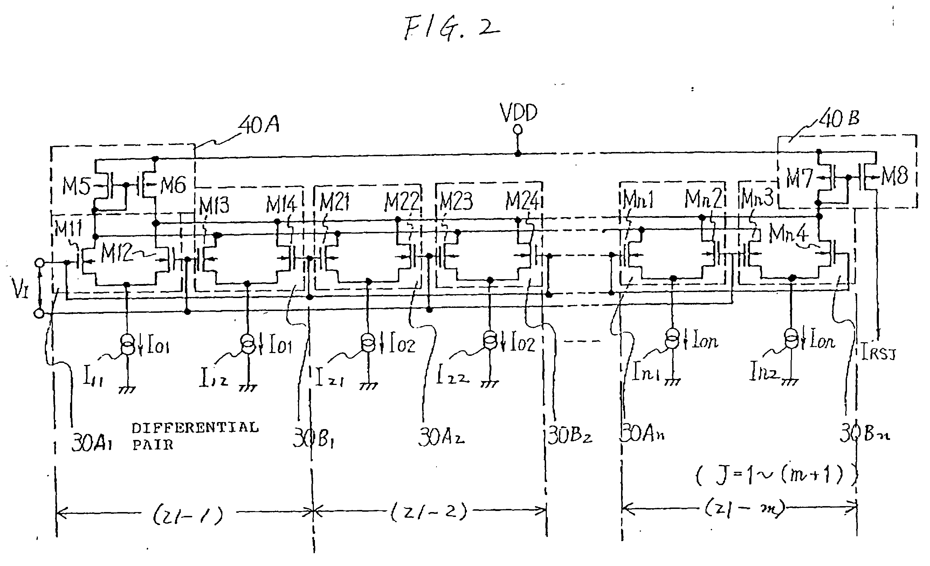

Since the logarithmic full-wave rectifiers 21, 22, ..., and 2(m+1) of the logarithmic amplifying circuit are all the same in circuitry arrangement, only the logarithmic full-wave rectifier 21 is shown in Fig. 2.

Referring to Fig. 2, the logarithmic full-wave rectifier 21 comprises n squaring full-wave rectifiers (21-1), (21-2), ..., and (21-n), and a pair of current mirror circuits 40A and 40B constituting an addition means for adding output currents from these squaring full-wave rectifiers. Each squaring full-wave rectifier is constituted by a set of two differential pairs. For example, in the squaring full-wave rectifier (21-1), a set of two differential pairs is constituted by differential pairs 30A₁ and 30B₁. In the squaring full-wave rectifier (21-2), a set of two differential pairs is constituted by differential pairs 30A₂ and 30B₂.

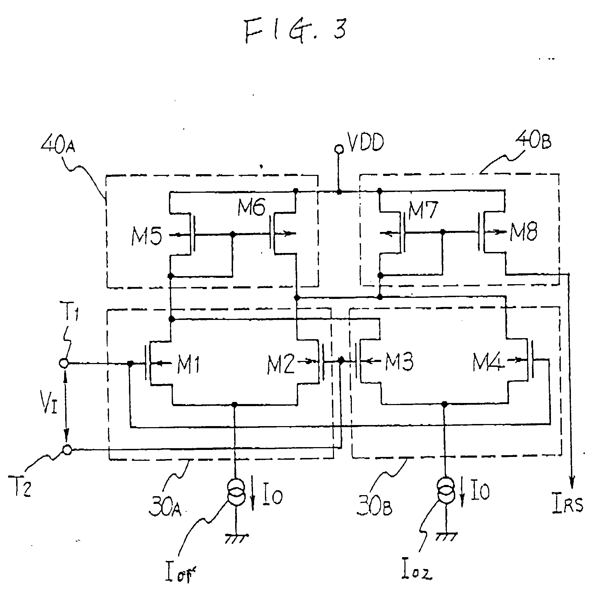

Since the squaring full-wave rectifiers are all the same in circuitry arrangement, only one of them is shown in Fig. 3, and its circuit arrangement and operation will be described below.

Referring to Fig. 3, each squaring full-wave rectifier comprises a set of two differential pairs 30A and 30B, and a pair of current mirror circuits 40A and 40B serving as an addition means. The differential pair 30A is constituted by first and second transistors M1 and M2. The gate of the first transistor M1 is connected to a first input terminal T₁, one of a pair of first and second input terminals T₁ and T₂ for receiving an input voltage V₁. The source of the transistor M1 is connected to a first current source I₀₁. The ratio of the gate width to the gate length of the transistor M1 is set to be a predetermined value. The gate and source of the second transistor M2 are respectively connected to the input terminal T₂ and the first current source I₀₁. The ratio of the gate width to the gate length of the second transistor M2 is set to be different from that of the first transistor M1. The other differential pair 30B is constituted by third and fourth transistors M3 and M4. The gate and source of the third transistor M3 are respectively connected to the second input terminal T₂ and a second current source I₀₂. The ratio of the gate width to the gate length of the third transistor M3 is set to be a predetermined value. The gate and source of the fourth transistor M4 are respectively connected to the first input terminal T₁ and the second current source I₀₂. The ratio (W/L) of the gate width to the gate length of the fourth transistor M4 is set such that the ratios (W/L) of the gate-width/gate-length of the third and fourth transistors M3 and M4 are equal to those of the first and second transistors M1 and M2.

The first current mirror circuits 40A comprises transistors M5 and M6. The current input terminals of the current mirror circuit 40A is connected to the drains of the first and third transistors M1 and M3, whereas the current output terminal is connected to the drains of the second and fourth transistors M2 and M4. The second current mirror circuit 40B comprises transistors M7 and M8. The current input terminal of the current mirror circuit 40B is connected to the drains of the second and fourth transistors M2 and M4 and to the current output terminal of the first current mirror circuit 40A.

The squaring full-wave rectifier shown in Fig. 3 requires the pair of current mirror circuits 40A and 40B. However, in the squaring full-wave rectifier shown in Fig. 2 which is constituted by a plurality of differential pairs, the pair of current mirror circuits 40A and 40B is commonly used for all the differential pairs (21-1), (21-2), ..., and (21-n)

An operation of this embodiment and the characteristics of the respective components will be described below.

The squaring full-wave rectifier will be described first.

Drain currents I_{d1}, I_{d2}, I_{d3}, and I_{d4} of the transistors M1, M2, M3, and M4 are obtained as follows. If ratios W/L of gate widths W to gate lengths L of the respective transistors are represented by W₁/L₁, W₂/L₂, W₃/L₃, and W₄/L₄, then${\text{(W}}_{\text{2}} {\text{/L}}_{\text{2}} {\text{)/(W}}_{\text{1}} {\text{/L}}_{\text{1}} {\text{) = (W}}_{\text{4}} {\text{/L}}_{\text{4}} {\text{)/(W}}_{\text{3}} {\text{/L}}_{\text{3}} \text{) = K > 1}$

In this case if${\text{β = µ}}_{\text{N}} \frac{{\text{C}}_{\text{ox}}}{\text{2}} \text{·} \frac{{\text{W}}_{\text{1}}}{{\text{L}}_{\text{1}}}$ where µ_{N} is the mobility of the transistor, and Cₒₓ is the gate capacitance of the gate oxide film per unit area, then${\text{I}}_{\text{d1}} {\text{= β (V}}_{\text{gs1}} {\text{- V}}_{\text{t}} {\text{)}}^{\text{2}}$${\text{I}}_{\text{d2}} {\text{= Kβ (V}}_{\text{gs2}} {\text{- V}}_{\text{t}} {\text{)}}^{\text{2}}$${\text{I}}_{\text{d3}} {\text{= β (V}}_{\text{gs3}} {\text{- V}}_{\text{t}} {\text{)}}^{\text{2}}$${\text{I}}_{\text{d4}} {\text{= Kβ (V}}_{\text{gs4}} {\text{- V}}_{\text{t}} {\text{)}}^{\text{2}}$ for${\text{I}}_{\text{d1}} {\text{+ I}}_{\text{d2}} {\text{= I}}_{\text{d3}} {\text{+ I}}_{\text{d4}} {\text{= I}}_{\text{0}}$${\text{V}}_{\text{I}} {\text{= V}}_{\text{gs1}} {\text{- V}}_{\text{gs2}} {\text{= V}}_{\text{gs4}} {\text{- V}}_{\text{gs3}}$ where Vₜ is the threshold voltage of the transistor.

The transistors M5, M6, M7, and M8 constitute the first and second current mirror circuits 40A and 40B, and an output current I_{RS} from this squaring full-wave rectifier is given by${\text{I}}_{\text{RS}} {\text{= (I}}_{\text{d2}} {\text{+ I}}_{\text{d4}} {\text{) - (I}}_{\text{d1}} {\text{+ I}}_{\text{d3}} \text{) = 2} \frac{\text{K-1}}{\text{K+1}} {\text{I}}_{\text{o}} \text{-4β} \frac{\text{K(K-1)}}{{\text{(K+1)}}^{\text{2}}} {\text{V}}_{\text{I}} {}^{\text{2}}$

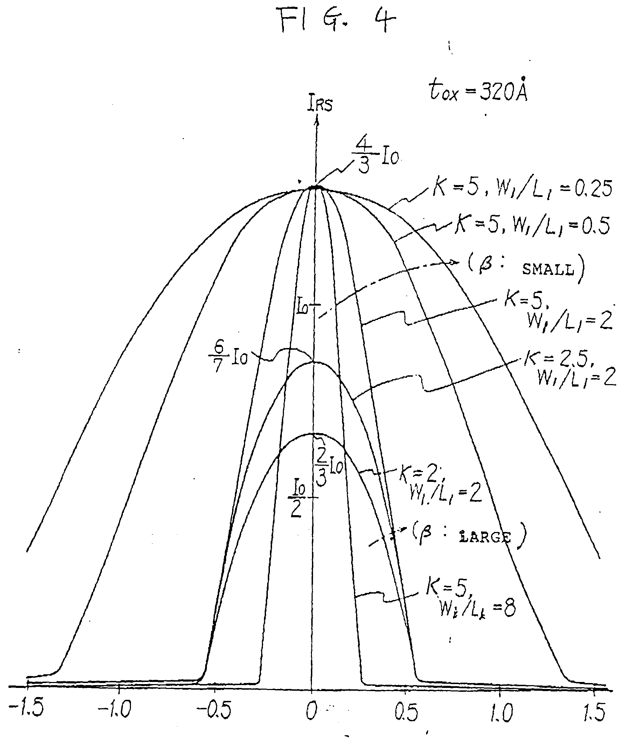

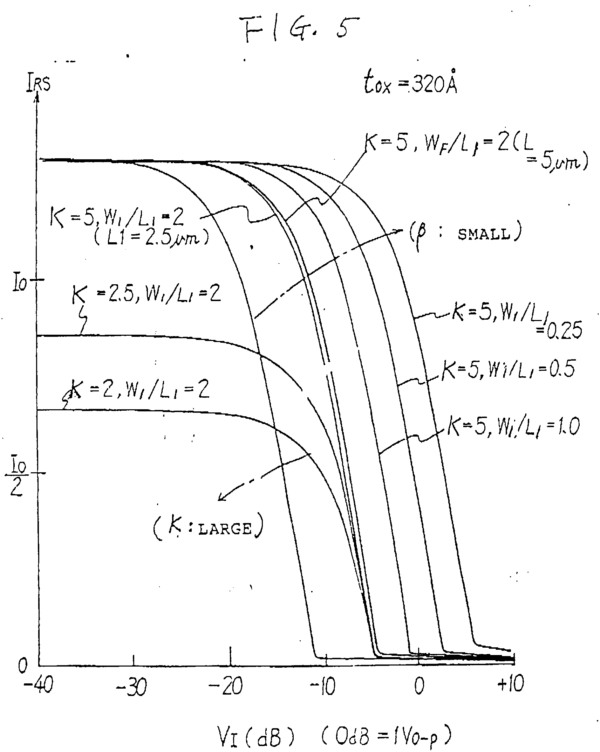

Fig. 4 shows this output current I_{RS} with K and W₁/L₁ used as parameters. Fig. 5 shows the output current I_{RS} as a function of V_{I}(dB).

The current I_{RSO} in equation (9) in the absence of a signal is given by${\text{I}}_{\text{RSO}} {\text{= I}}_{\text{RS}} {\text{(V}}_{\text{l}} \text{= 0) = 2} \frac{\text{K-1}}{\text{K+1}} {\text{I}}_{\text{o}}$ The current I_{RSO} monotonously increases with respect to K.

According to equation (9), if I_{RS} = 0, an operating maximum input voltage V_{I0} is given by${\text{V}}_{\text{l0}} \text{=} \sqrt{\text{1 +} \frac{\text{1}}{\text{K}}} \text{·} \sqrt{\frac{{\text{I}}_{\text{o}}}{\text{2β}}}$ Even if the value K changes, the range of change is sufficiently compressed. Therefore, the voltage V_{I0} is substantially constant, if K has a large value.

Similarly, an input voltage V_{I0.5} for I_{RS} = I_{RSO}/2 is given by${\text{V}}_{\text{I0.5}} \text{=} \frac{\text{1}}{\text{2}} \sqrt{\text{1 +} \frac{\text{1}}{\text{K}}} \text{·} \sqrt{\frac{{\text{I}}_{\text{o}}}{\text{β}}} \text{=} \frac{\text{1}}{\sqrt{\text{2}}} {\text{V}}_{\text{I0}}$ Therefore, the input voltage v_{I0.5} remains substantially constant with respect to a change in K.

The inclination of the current I_{RS} is obtained by differentiating equation (9) as follows:$\frac{{\text{dI}}_{\text{RS}}}{{\text{dV}}_{\text{I}}} \text{=} \frac{{\text{-8β K(K-1) V}}_{\text{I}}}{{\text{(K + 1)}}^{\text{2}}}$

For example, when I_{RS} becomes I_{RSO}/2, the corresponding inclination is represented by$\frac{{\text{dI}}_{\text{RS}}}{{\text{dV}}_{\text{I}}} {\text{(V}}_{\text{I}} {\text{= V}}_{\text{I0.5}} \text{) = -4} \frac{\text{(K-1)}}{\text{(K+1)}} \sqrt{\frac{\text{K}}{\text{K+1}}} \sqrt{{\text{βI}}_{\text{0}}}$

That is, the current I_{RS} monotonously decreases with respect to K.

The caracteristics of the logarithmic full-wave rectifier 2J (J= 1 to m+1) will be described below.

The operating dynamic range of the Xth (X= 1 to n) squaring full-wave rectifier constituting the logarithmic full-wave rectifier is represented as the following equations by superposing the product by P_{X} on I_{RSX}, provided that the range of charge in output current I_{RSX} is set to be (1 - 2P_{X}) times the current I_{RSXO} (0 <P_{X}< 0.5):${\text{V}}_{\text{I1}} {\text{(1 - P}}_{\text{1}} {\text{) = V}}_{\text{I2}} {\text{(P}}_{\text{2}} \text{)}$${\text{v}}_{\text{I2}} {\text{(1 - P}}_{\text{2}} {\text{) = V}}_{\text{I3}} {\text{(P}}_{\text{3}} \text{)}$${\text{V}}_{\text{I(n-1)}} {\text{{1-P}}_{\text{(n-1)}} {\text{} = V}}_{\text{In}} {\text{(P}}_{\text{n}} \text{)}$ In this case, V_{IX} (P_{X}) and V_{IX} (1 - P_{X}) respectively represent input voltages at which the current I_{RSX} is P_{X} and (1 - P_{X}) times I_{RSXO} (= I_{RSX} (V_{IX} = 0)).

In this case, an operating dynamic range d of a logarithmic full-wave rectifier 2J is given by${\text{d = V}}_{\text{I1}} {\text{(P}}_{\text{1}} {\text{)/V}}_{\text{In}} {\text{(1 - P}}_{\text{n}} \text{)}$

If this value is expressed logarithmically,${\text{D(dB) = V}}_{\text{I1}} {\text{(P}}_{\text{1}} {\text{) (dB) - V}}_{\text{In}} {\text{(1 - P}}_{\text{n}} \text{) (dB)}$

According to equations (9) and (10),${\text{V}}_{\text{IX}} {\text{(1 - P}}_{\text{X}} \text{) =} \sqrt{\frac{{\text{P}}_{\text{X}}}{\text{2}} \text{·} \frac{{\text{K}}_{\text{X}} \text{+ 1}}{{\text{β}}_{\text{X}} {\text{K}}_{\text{X}}} {\text{I}}_{\text{OX}}}$${\text{V}}_{\text{IX}} {\text{(P}}_{\text{X}} \text{) =} \sqrt{\frac{{\text{1 - P}}_{\text{X}}}{\text{2}} \text{·} \frac{{\text{K}}_{\text{X}} \text{+ 1}}{{\text{β}}_{\text{X}} {\text{K}}_{\text{X}}} {\text{I}}_{\text{OX}}}$ Hence,

Therefore, the dynamic range d is obtained by$\text{d =} \sqrt{\frac{{\text{1-P}}_{\text{1}}}{{\text{P}}_{\text{n}}}} \text{·} \sqrt{\frac{{\text{K}}_{\text{n}} \text{(K+1)}}{{\text{K}}_{\text{1}} {\text{(K}}_{\text{n}} \text{+ 1)}}} \text{·} \sqrt{\frac{{\text{I}}_{\text{O1}}}{{\text{I}}_{\text{On}}}} \text{·} \sqrt{\frac{{\text{β}}_{\text{n}}}{{\text{β}}_{\text{1}}}}$

For example, if${\text{K}}_{\text{1}} {\text{= K}}_{\text{2}} {\text{= .... = K}}_{\text{n}}$${\text{I}}_{\text{01}} {\text{= I}}_{\text{02}} {\text{= ... = I}}_{\text{On}}$ then,$\text{d =} \sqrt{\frac{{\text{1-P}}_{\text{1}}}{{\text{P}}_{\text{n}}}} \sqrt{\frac{{\text{β}}_{\text{n}}}{{\text{β}}_{\text{1}}}} \text{=} \sqrt{\frac{{\text{1-P}}_{\text{1}}}{{\text{P}}_{\text{n}}}} \sqrt{\frac{{\text{β}}_{\text{n}}}{{\text{β}}_{\text{1}}}}$

According to equations (15) to (17),$\frac{{\text{P}}_{\text{(X-1)}}}{{\text{β}}_{\text{(X-1)}}} \text{=} \frac{{\text{1-P}}_{\text{X}}}{{\text{β}}_{\text{X}}}$$\text{∴} \frac{{\text{β}}_{\text{X}}}{{\text{β}}_{\text{(X-1)}}} \text{=} \frac{{\text{1-P}}_{\text{X}}}{{\text{P}}_{\text{(X-1)}}}$$\text{∴} \frac{{\text{β}}_{\text{n}}}{{\text{β}}_{\text{1}}} \text{=} \frac{{\text{β}}_{\text{n}}}{{\text{β}}_{\text{(n-1)}}} \text{·} \frac{{\text{β}}_{\text{(n-1)}}}{{\text{β}}_{\text{(n-2)}}} \text{· ··· ·} \frac{{\text{β}}_{\text{2}}}{{\text{β}}_{\text{1}}} \text{=} \frac{{\text{1-P}}_{\text{n}}}{{\text{P}}_{\text{(n-1)}}} \text{·} \frac{{\text{1-P}}_{\text{(n-1)}}}{{\text{P}}_{\text{(n-2)}}} \text{· ··· ·} \frac{{\text{1-P}}_{\text{2}}}{{\text{P}}_{\text{1}}}$$\text{∴ d =} \sqrt{\frac{{\text{1-P}}_{\text{n}}}{{\text{P}}_{\text{n}}} \text{·} \frac{{\text{1-P}}_{\text{(n-1)}}}{{\text{P}}_{\text{(n-1)}}} \text{· ··· ·} \frac{{\text{1-P}}_{\text{2}}}{{\text{P}}_{\text{2}}} \frac{{\text{1-P}}_{\text{1}}}{{\text{P}}_{\text{1}}}}$

The magnitude of a logarithmic characteristic error of the logarithmic full-wave rectifier 2J is determined by P_{X}. In order to reduce the error, the value P_{X} needs to be increased.

If, for example,${\text{P}}_{\text{1}} {\text{= P}}_{\text{2}} {\text{= ···= P}}_{\text{n}} \text{= 0.1}$ then,${\text{∴ d = 3}}^{\text{n}}$

If this value is expressed in terms of dB,$\text{D(dB) = 9.54 x n(dB)}$

As a result, an operating dynamic range of 9.54 dB is obtained per squaring full-wave rectifier.

In addition, if${\text{P}}_{\text{1}} {\text{= P}}_{\text{2}} {\text{= ··· = P}}_{\text{n}} \text{= 0.2}$ then,${\text{d = 2}}^{\text{n}}$

If this value is expressed in terms of dB,$\text{d(dB) = 6.02 x n(dB)}$

As a result, an operating dynamic range of 6.02 dB is obtained per squaring full-wave rectifier. If the value P_{X} is increases, the operating dynamic range is reduced. However, since the operating dynamic range is increased n times at the output terminal of the logarithmic full-wave rectifier 2J, an operating dynamic range much wider than that of the conventional circuit can be obtained.

Since output currents I_{RSJ} from the logarithmic full-wave rectifiers 2J having such characteristics are added together by the adder 3, and the sum current is converted into an output voltage V₀, the output voltage V₀ has a dynamic range of d^{(m+1)}. With this operation, excellent logarithmic characteristics with a wide dynamic range and a small error can be obtained.

As has been described above, according to the present invention, logarithmic full-wave rectifiers are respectively connected to the input and output terminals of a plurality of stages full-wave of cascaded differential amplifiers. Each logarithmic full-wave rectifier has a plurality of squaring full-wave rectifiers which perform squaring full-wave rectification of corresponding signals at these input and output terminals. The logarithmic full-wave rectifier adds the outputs from the squaring full-wave rectifiers, and output the sum. The outputs from the respective logarithmic full-wave rectifiers are added together. With this operation, excellent logarithmic characteristics with a wide dynamic range and a small error can be obtained.

## Claims

1. A logarithmic amplifier comprising:
a) a plurality of differential amplifier stages (11,12) each having first and second input nodes and first and second output nodes, said amplifier stages being connected to each other in cascaded arrangement such that said first and second output nodes of a preceding amplifier stage are connected respectively to said first and second input nodes of a succeeding amplifier stage, an input signal being supplied between said first and second input nodes of a first stage (11) of said cascaded arrangement;
b) a plurality of logarithmic full wave rectifier blocks (21,22), each rectifier block having first and second input terminals (T1,T2) one rectifier block having its input terminals respectively connected to the first and second input nodes of the first amplifier stage, the other rectifier blocks having their input terminals respectively connected to said first and second output nodes of an associated one of said amplifier stages (11,12) to receive an output signal appearing between said first and second output nodes of the associated amplifier stage, each rectifier block rectifying its respective input signal to produce an output current at first and second output terminals thereof and having logarithmic full-wave rectification with respect to an input voltage;
c) an adder (3) to add output currents from said rectifier blocks (21,22) to each other and output a signal corresponding to the sum current;
characterised in that
d) each rectifier block (21,22) includes a first current source (111), first and second MOS transistors (M11,M12) connected in a differential manner, said first MOS transistor (M11) having a gate connected to said first input terminal (T1), a drain connected to said first output terminal, a source directly connected to said first current source and a first ratio (W1/L1) of a gate width to a gate length, said second MOS transistor (M12) having a gate connected to said second input terminal (T2), a drain connected to said second output terminal, a source directly connected to said first current source and a second ratio of a gate width to a gate length, said first ratio being different from said second ratio, a second current source (I12), third and fourth MOS transistors (M13,M14) connected in a differential manner, said third MOS transistor (M13) having a gate connected to said second input terminal (T2), a drain connected to said first output terminal, a source directly connected to said second current source and a third ratio of a gate width to a gate length, said fourth MOS transistor (M14) having a gate connected to said first input terminal, a drain connected to said second output terminal, a source directly connected to said second current source and a fourth ratio of a gate width to a gate length, said third ratio being different from said fourth ratio, a third current source (I21), fifth and sixth MOS transistors (M21,M22) connected in a differential manner, said fifth MOS transistor (M21) having a gate connected to said first input terminal, a drain connected to said first output terminal, a source directly connected to said third current source and a fifth ratio of a gate width to a gate length, said sixth MOS transistor (M22) having a gate connected to said second input terminal, a drain connected to said second output terminal, a source directly connected to said third current source and a sixth ratio of a gate width to a gate length, said fifth ratio being different from said sixth ratio, a fourth current source (I22), seventh and eighth MOS transistors (M23,M24) connected in a differential manner, said seventh MOS transistor (M23) having a gate connected to said second input terminal, a drain connected to said first output terminal, a source directly connected to said fourth current source and a seventh ratio of a gate width to a gate length, said eighth MOS transistor (M24) having a gate connected to said first input terminal, a drain connected to said second output terminal, a source directly connected to said fourth current source and an eighth ratio of a gate width to a gate length, said seventh ratio being different from said eighth ratio, and an output circuit (30Bn, 40A, 40B) connected to said first and second output terminals for adding the currents output from said rectifier blocks.

2. An amplifier according to Claim 1, wherein said output circuit of said each rectifier block includes a first current mirror circuit (40A) having a current input terminal connected to said first output terminal of each rectifier block and thereby supplied commonly with drain currents of said first, third, fifth and seventh MOS transistors and a current output terminal connected to the drains of the second, fourth, sixth and eighth MOS transistors, and a second current mirror circuit (40B) having a current input terminal connected to said second output terminal of said each rectifier block and thereby supplied commonly with drain currents of said second, fourth, sixth and eighth MOS transistors and to the current output terminal of said first current circuit, said second current mirror circuit providing via its output terminal a sub total current (IRS1) representing said output signal of said each rectifier block.

## Patentansprüche

1. Logarithmischer Verstärker, der aufweist:
a) eine Vielzahl von Differenzverstärkerstufen (11, 12), die jeweils erste und zweite Eingangsknotenpunkte und erste und zweite Ausgangsknotenpunkte haben, wobei die Verstärkerstufen miteinander in Kaskadenanordnung verbunden sind, so daß die ersten und zweiten Ausgangsknotenpunkte einer vorangehenden Verstärkerstufe mit den ersten bzw. zweiten Eingangsknotenpunkten einer nachfolgenden Verstärkerstufe verbunden sind, wobei ein Eingangssignal zwischen den ersten und zweiten Eingangsknotenpunkten einer ersten Stufe (11) der kaskadenförmigen Anordnung angelegt wird;
b) eine Vielzahl von logarithmischen Vollwellengleichrichterblöcken (21, 22), wobei jeder Gleichrichterblock erste und zweite Eingangsanschlüsse (T1, T2) aufweist, wobei die Eingangsanschlüsse eines Gleichrichterblocks mit den ersten und zweiten Eingangsknotenpunkten der ersten Verstärkerstufe verbunden sind, wobei die Eingangsanschlüsse der anderen Gleichrichterblöcke mit den ersten und zweiten Ausgangsknotenpunkten einer damit verknüpften der Verstärkerstufen (11, 12) verbunden ist, um ein Ausgangssignal zu empfangen, das zwischen den ersten und zweiten Ausgangsknotenpunkten der damit verknüpften Verstärkerstufe erscheint, wobei jeder Gleichrichterblock sein entsprechendes Eingangssignal gleichrichtet, um einen Ausgangsstrom an seinen ersten und zweiten Ausgangsanschlüssen zu erzeugen und logarithmische Vollwellengleichrichtung in bezug auf eine Eingangsspannung hat;
c) einen Addierer (3), um Ausgangsströme von den Gleichrichterblöcken (21, 22) zueinander zu addieren und ein Signal auszugeben, das dem Summenstrom entspricht;
dadurch gekennzeichnet, daß
d) jeder Gleichrichterblock (21, 22) eine erste Stromquelle (I11), erste und zweite MOS-Transistoren (M11, M12), die in Differenzweise miteinander verbunden sind, wobei der erste MOS-Transistor (M11) mit seinem Gate mit dem ersten Eingangsanschluß (T1), mit seinem Drain mit dem ersten Ausgangsanschluß und mit seiner Source direkt mit der ersten Stromquelle verbunden ist und ein erstes Verhältnis (W1/L1) einer Gatebreite zur Gatelänge hat, wobei der zweite MOS-Transistor (M12) mit seinem Gate mit dem zweiten Eingangsanschluß (T2), mit seinem Drain mit dem zweiten Ausgangsanschluß, mit seiner Source direkt mit der ersten Stromquelle verbunden ist und ein zweites Verhältnis einer Gatebreite zur Gatelänge hat, wobei das erste Verhältnis vom zweiten Verhältnis verschieden ist, eine zweite Stromquelle (I12), dritte und vierte MOS-Transistoren (M13, M14), die in differentieller Weise verbunden sind, wobei der dritte MOS-Transistor (M13) mit seinem Gate mit dem zweiten Eingangsanschluß (T2), mit seinem Drain mit dem ersten Ausgangsanschluß, mit seiner Source direkt mit der zweiten Stromquelle verbunden ist und ein drittes Verhältnis einer Gatebreite zur Gatelänge hat, wobei der vierte MOS-Transistor (M14) mit seinem Gate mit dem ersten Eingangsanschluß, mit seinem Drain mit dem zweiten Ausgangsanschluß, mit seiner Quelle direkt mit der zweiten Stromquelle verbunden ist und ein viertes Verhältnis einer Gatebreite zur Gatelänge hat, wobei das dritte Verhältnis vom vierten Verhältnis verschieden ist, eine dritte Stromquelle (I21), fünfte und sechsts MOS-Transistoren (M21, M22), die in differentieller Weise verbunden sind, wobei der fünfte MOS-Transistor (M21) mit seinem Gate mit dem ersten Eingangsanschluß, mit seinem Drain mit dem ersten Ausgangsanschluß, mit seiner Source direkt mit der dritten Stromquelle verbunden ist und ein fünftes Verhältnis einer Gatebreite zur Gatelänge hat, wobei der sechste MOS-Transistor (M22) mit seinem Gate mit dem zweiten Eingangsanschluß, mit seinem Drain mit dem zweiten Ausgangsanschluß, mit seiner Source direkt mit der dritten Stromquelle verbunden ist und ein sechstes Verhältnis einer Gatebreite zur Gatelänge hat, wobei das fünfte Verhältnis vom sechsten Verhältnis verschieden ist, eine vierte Stromquelle (I22), siebte und achte MOS-Transistoren (M23, M24), die in differentieller Weise verbunden sind, wobei der siebte MOS-Transistor (M23) mit seinem Gate mit dem zweiten Eingangsanschluß, mit seinem Drain mit dem ersten Aus-gangsanschluß, mit seiner Source direkt mit der vierten Stromquelle verbunden ist und ein siebtes Verhältnis einer Gatebreite zur Gatelänge hat, wobei der achte MOS-Transistor (M24) mit seinem Gate mit dem ersten Eingangsanschluß, mit seinem Drain mit dem zweiten Ausgangsanschluß, mit seiner Source direkt mit der vierten Stromquelle verbunden und ein achtes Verhältnis einer Gatebreite zur Gatelänge hat, wobei das siebte Verhältnis vom achten Verhältnis verschieden ist, und eine Ausgangsschaltung (30Bn, 40A, 40B) aufweist, die mit den ersten und zweiten Ausgangsanschlüssen verbunden ist, um die Ströme zu addieren, die von den Gleichrichterblöcken abgegeben werden.

2. Verstärker nach Anspruch 1, bei dem die Ausgangsschaltung jedes Gleichrichterblocks eine erste Stromspiegelschaltung (40A), die mit einem Stromeingangsanschluß mit dem ersten Ausgangsanschluß jedes Gleichrichterblocks verbunden ist und dadurch gemeinsam mit Drainströmen der ersten, dritten, fünften und siebten MOS-Transistoren gespeist wird, und die mit einem Stromausgangsanschluß mit den Drains der zweiten, vierten, sechsten und achten MOS-Transistoren verbunden ist, und eine zweite Stromspiegelschaltung (40B) aufweist, die mit einem Stromeingangsanschluß mit dem zweiten Ausgangsanschluß jedes Gleichrichterblocks verbunden ist und dadurch gemeinsam mit Drainströmen von den zweiten, vierten, sechsten und achten MOS-Transistoren gespeist wird, und mit dem Stromausgangsanschluß der ersten Stromschaltung verbunden ist, wobei die zweite Stromspiegelschaltung über ihren Ausgangsanschluß einen Untergesamtstrom (IRS1) abgibt, der das Ausgangssignal jedes Gleichrichterblocks darstellt.

## Revendications

1. Amplificateur logarithmique comprenant :
a) une pluralité d'étages amplificateurs différentiels (11, 12) ayant chacun des premier et second noeuds d'entrée et des premier et second noeuds de sortie, lesdits étages amplificateurs étant reliés les uns aux autres dans une disposition en cascade de sorte que lesdits premier et second noeuds de sortie d'un étage amplificateur précédent sont respectivement reliés auxdits premier et second noeuds d'entrée d'un étage amplificateur suivant, un signal d'entrée étant délivré entre lesdits premier et second noeuds d'entrée d'un premier étage (11) de ladite disposition en cascade ;
b) une pluralité de blocs redresseurs logarithmiques à deux alternances (21, 22), chaque bloc redresseur ayant des première et seconde bornes d'entrée (T1, T2), un bloc redresseur particulier ayant ses bornes d'entrée respectivement reliées aux premier et second noeuds d'entrée du premier étage amplificateur, les autres blocs redresseurs ayant leurs bornes d'entrée respectivement reliées auxdits premier et second noeuds de sortie d'un étage associé desdits étages amplificateurs (11, 12) pour recevoir un signal de sortie apparaissant entre lesdits premier et second noeuds de sortie de l'étage amplificateur associé, chaque bloc redresseur redressant son signal d'entrée respectif pour produire un courant de sortie au niveau des première et seconde bornes de sortie de ce dernier et ayant un redressement logarithmique à deux alternances par rapport à une tension d'entrée ;
c) un additionneur (3) pour additionner des courants de sortie en provenance desdits blocs redresseurs (21, 22) les uns aux autres et pour sortir un signal correspondant au courant de somme ;
caractérisé en ce que
d) chaque bloc redresseur (21, 22) comprend une première source de courant (I11), des premier et second transistors MOS (M11, M12) reliés de façon différentielle, ledit premier transistor MOS (M11) ayant sa grille reliée à ladite première borne d'entrée (T1), son drain relié à ladite première borne de sortie, sa source directement reliée à ladite première source de courant et un premier rapport (W1/L1) de la largeur de la grille sur la longueur de la grille, ledit second transistor MOS (M12) ayant sa grille reliée à ladite seconde borne d'entrée (T2), son drain relié à ladite seconde borne de sortie, sa source directement reliée à ladite première source de courant et un second rapport de la largeur de la grille sur la longueur de la grille, ledit premier rapport étant différent dudit second rapport, une seconde source de courant (I12), des troisième et quatrième transistors MOS (M13, M14) reliés de façon différentielle, ledit troisième transistor MOS (M13) ayant sa grille reliée à ladite seconde borne d'entrée (T2), son drain relié à ladite première borne de sortie, sa source directement reliée à ladite seconde source de courant en un troisième rapport de la largeur de la grille sur la longueur de la grille, ledit quatrième transistor MOS (M14) ayant sa grille reliée à ladite première borne d'entrée, son drain relié à ladite seconde borne de sortie, sa source directement reliée à ladite seconde source de courant et un quatrième rapport de la largeur de la grille sur la longueur de la grille, ledit troisième rapport étant différent dudit quatrième rapport, une troisième source de courant (I21), des cinquième et sixième transistors MOS (M21, M22) reliés de façon différentielle, ledit cinquième transistor MOS (M21) ayant sa grille reliée à ladite première borne d'entrée, son drain relié à ladite première borne de sortie, sa source directement reliée à ladite troisième source de courant et un cinquième rapport de la largeur de la grille sur la longueur de la grille, ledit sixième transistor MOS (M22) ayant sa grille reliée à ladite seconde borne d'entrée, son drain relié à ladite seconde borne de sortie, sa source directement reliée à ladite troisième source de courant et un sixième rapport de la largeur de la grille sur la longueur de la grille, ledit cinquème rapport étant différent dudit sixième rapport, une quatrième source de courant (I22), des septième et huitième transistors MOS (M23, M24) reliés de façon différentielle, ledit septième transistor MOS (M23) ayant sa grille reliée à ladite seconde borne d'entrée, son drain relié à ladite première borne de sortie, sa source directement reliée à ladite quatrième source de courant et un septième rapport de la largeur de la grille sur la longueur de la grille, ledit huitième transistor MOS (M24) ayant sa grille reliée à ladite première borne d'entrée, son drain relié à ladite seconde borne de sortie, sa source directement reliée à ladite quatrième source de courant et un huitième rapport de la largeur de la grille sur la longueur de la grille, ledit septième rapport étant différent dudit huitième rapport, et un circuit de sortie (30Bn, 40A, 40B) relié auxdites première et seconde bornes de sortie pour additionner les courants sortis desdits blocs redresseurs.

2. Amplificateur selon la revendication 1, dans lequel ledit circuit de sortie de chaque dit bloc redresseur comprend un premier circuit formant miroir de courant (40A) ayant une borne d'entrée de courant reliée à ladite première borne de sortie de chaque bloc redresseur et alimenté ordinairement, de ce fait, par les courants de drain desdits premier, troisième, cinquième et septième transistors MOS et ayant une borne de sortie de courant reliée aux drains des second, quatrième, sixième et huitième transistors MOS, et comprend un second circuit formant miroir de courant (40B) ayant une borne d'entrée de courant reliée à ladite seconde borne de sortie de chaque dit bloc redresseur et alimenté ordinairement, de ce fait, par les courants de drain desdits second, quatrième, sixième et huitième transistors MOS et à la borne de sortie de courant dudit premier circuit de courant, ledit second circuit formant miroir de courant donnant, par l'interniédiaire de sa borne de sortie, un courant secondaire total (IRS1) représentant ledit signal de sortie de chaque dit bloc redresseur.
